# EUROPEAN PATENT APPLICATION

(11) **EP 3 859 803 A1**
(43) Date of publication of application: **04.08.2021**
(21) Application number: 19865475.8
(22) Date of filing: 20.09.2019
(51) Int. Cl.: H01L 41/313, C23C 14/50, H01L 41/113, H01L 41/187, H01L 41/319

(54) **PIEZOELECTRIC DEVICE AND METHOD OF MANUFACTURING PIEZOELECTRIC DEVICE**

(30) Priority: 28.09.2018 JP 2018185551
(71) Applicant: Nitto Denko Corporation, Ibaraki-shi, Osaka 567-8680 (JP)
(72) Inventor: NAGAOKA, Naoki, Ibaraki-shi, Osaka 567-8680 (JP); NAKAMURA, Daisuke, Ibaraki-shi, Osaka 567-8680 (JP)
(74) Representative: Müller-Boré & Partner Patentanwälte PartG mbB
(86) International application number: PCT/JP2019/037081
(87) International publication number: WO 2020/066936

(57) **Abstract**

A piezoelectric device has a good piezoelectric characteristic, while suppressing a leakage current between electrodes. The piezoelectric device has a first substrate, a first conductive film provided on the first substrate, a piezoelectric layer formed of an inorganic material and provided on the first conductive film, an adhesive layer provided on the piezoelectric layer, and a second conductive film provided on the adhesive layer.

## Description

### TECHNICAL FIELD

The present invention relates to a piezoelectric device and a method of manufacturing the same.

### BACKGROUND ART

Piezoelectric devices, which make use of the piezoelectric effect of substances, have conventionally been adopted. The piezoelectric effect is a phenomenon in which microscopic polarization is produced in response to a mechanical stress applied to a substance. Using the piezoelectric effect, various sensors including pressure sensors, acceleration sensors, and acoustic emission (AE) sensors for detecting elastic waves are commercially available.

In recent years, touch panels have been used as input interfaces of electronic devices such as smartphones, and piezoelectric devices are often applied to the touch panels. A touch panel is integrated into the display device of electronic equipment. In this case, it would be necessary to the piezoelectric layer to be highly responsive to pressure in order to accurately detect manipulations by a finger. Applications to biological sensors are also expected to detect biological signals such as pulse rate or respiratory rate. High sensitivity is again required for such applications.

As a transparent piezoelectric sheet, a configuration in which a transparent piezoelectric film of an organic polymer and a transparent flat-plate electrode are bonded together using an adhesive layer is known.

### SUMMARY OF THE INVENTION

### TECHNICAL PROBLEM TO BE SOLVED

A piezoelectric device typically has a multilayer structure in which a piezoelectric layer is provided between a pair of electrodes. When a crystalline piezoelectric material is used, a piezoelectric layer having a certain degree of thickness is needed to improve the crystal orientation. However, the greater the thickness of the piezoelectric layer, the more likely cracking or pinholes will occur. When there is a foreign substance or a grain boundary at the interface between the piezoelectric layer and the electrode, a leakage current path is generated between the electrodes due to cracking or pinholes, and the electric charge generated in the piezoelectric layer disappears. Meanwhile, from the general trend to downsize the device dimensions, it is desired to reduce the thickness of the piezoelectric layer; however, the thinner the piezoelectric layer, the more remarkable the problem of the leakage current between the electrodes.

An objective of the present invention is to provide a piezoelectric device having satisfactory piezoelectric characteristics, while suppressing leakage current between electrodes, and a method of manufacturing the same.

### TECHNICAL SOLUTION(S)

In the present invention, an adhesive layer is provided between the piezoelectric layer and an electrode to prevent a leakage current path that short-circuits between the electrode from being generated in the piezoelectric.

In one aspect, a piezoelectric device has a first substrate, a first conductive film provided on the first substrate, a piezoelectric layer formed of an inorganic material and provided on the first conductive film, an adhesive layer provided on the piezoelectric layer, and a second conductive film provided on the adhesive layer.

In a preferred example, an amorphous orientation control layer may be provided between the first conductive film and the piezoelectric layer.

In another aspect, a method of manufacturing a piezoelectric device includes
fabricating a first subassembly by stacking a first conductive film on a first substrate and stacking a piezoelectric layer of an inorganic material on the first conductive film,
fabricating a second subassembly by stacking a second conductive film on a second substrate, and
bringing the second conductive film so as to face the piezoelectric layer and bonding the first subassembly and the second subassembly by an adhesive layer.

### ADVANTAGEOUS EFFECT OF THE INVENTION

With the above-described configuration and method, a piezoelectric device in which leakage current is suppressed between the electrodes is achieved.

### BRIEF DESCRIPTION OF DRAWINGS

FIG. 1 is a schematic diagram of a piezoelectric device according to an embodiment;
FIG. 2A shows a manufacturing process of the piezoelectric device of FIG. 1;
FIG. 2B shows a manufacturing process of the piezoelectric device of FIG. 1;
FIG. 3 shows a modified structure of the piezoelectric device;
FIG. 4A shows a manufacturing process of the piezoelectric device of FIG. 3;
FIG. 4B shows a manufacturing process of the piezoelectric device of FIG. 3; and
FIG. 5 shows the evaluation result of the piezoelectric device, together with the evaluation result of a comparative example.

### DESCRIPTION OF PREFERRED EMBODIMENT(S)

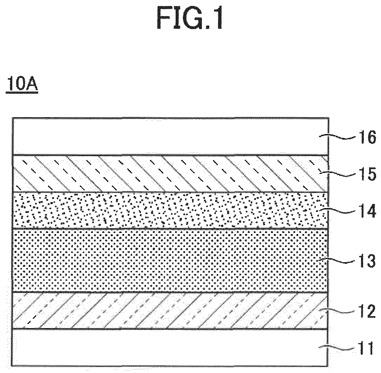

FIG. 1 is a schematic diagram of a piezoelectric device 10A according to an embodiment. The piezoelectric device 10A is applied to, for example, a piezoelectric sensor configured to output an electric signal proportional to an externally applied pressure.

In the piezoelectric device 10A, a conductive film 12, a piezoelectric layer 13, an adhesive layer 14, a conductive film 15, and a substrate 16 are stacked in this order on another substrate 11. By providing the adhesive layer 14 between the piezoelectric layer 13 and the conductive film 15, leakage current paths are prevented from being generated between the conductive film 15 and the conductive film 12.

The substrate 11 may be a glass substrate or a plastic substrate. If a plastic substrate is used, it may be a flexible plastic substrate that imparts flexibility to the piezoelectric device 10A. As the plastic substrate, polyethylene terephthalate (PET), polyethylene naphthalate (PEN), polycarbonate (PC), acrylic resin, cycloolefin polymer, polyimide (PI), etc. may be used.

Among these materials, PET, PEN, PC, acrylic resin, and cycloolefin polymer are colorless and transparent materials, and suitably used when light transmission is required for the piezoelectric device 10A. In applications of the piezoelectric device 10A in which light transmission is not essential, such as applications to health-care products (including pulse rate monitors or heart rate monitors) or to vehicle pressure-sensor sheets, then a semitransparent or opaque plastic material may be used.

The conductive film 12 serves as a bottom electrode in the example of FIG. 1. The conductive film 12 is a transparent film of a conductive oxide such as indium tin oxide (ITO), indium zinc oxide (IZO), indium zinc tin oxide (IZTO), indium gallium zinc oxide (IGZO), or the like. Although the transparency is not essential for the conductive film 12, a transparent conductive film formed of ITO, IZO, IZTO, IGZO, or the like is preferred when the piezoelectric device 10A is applied to a display such as a touch panel.

From the viewpoint of suppressing the roughness or the crystal grain boundaries at the interface between the conductive film 12 and the piezoelectric layer 13, the conductive oxide film may be an amorphous film. By using an amorphous film, the surface roughness or the crystal grain boundary that tends to cause leakage current paths can be reduced. Further, the subsequently formed piezoelectric layer 13 can grow with good crystal orientation without being affected by the crystal axes of the conductive film 12.

The piezoelectric layer 13 is formed of an inorganic piezoelectric material, and may have, for example, a wurtzite crystal structure. The thickness of the piezoelectric layer 13 is 50 nm to 400 nm, for example. By setting the thickness of the piezoelectric layer 13 in this range, cracking or crazing cracks can be suppressed. If the thickness of the piezoelectric layer 13 exceeds 400 nm, the likelihood of occurrence of cracking or crazing increases, which may affect transparency or haze (opaqueness). If the thickness of the piezoelectric layer 13 is less than 50 nm, it is difficult to maintain a sufficient degree of piezoelectric characteristic (or polarization proportional to pressure).

A wurtzite crystal has a hexagonal unit cell, and the polarization vector is in the direction parallel to the c-axis. Examples of wurtzite crystal include, but are not limited to zinc oxide (ZnO), zinc sulfide (ZnS), zinc selenide (ZnSe), zinc telluride (ZnTe), aluminum nitride (AlN), gallium nitride (GaN), cadmium selenide (CdSe), cadmium telluride (CdTe), and silicon carbide (SiC). The above-described compounds may be used individually or in combinations of two or more compounds. When two or more of these compounds are combined, layers of the selected compounds may be stacked one by one. The selected compound or a combination of two or more of these compounds may be used as the main component forming the wurtzite crystal. Alternatively, additional components may optionally be added as subcomponents to the wurtzite crystal.

A metal that can maintain the non-conductive property of the wurtzite crystal when contained in the wurtzite crystal may be added as a dopant. Examples of such a metal include, but are not limited to silicon (Si), magnesium (Mg), vanadium (V), titanium (Ti), zirconium (Zr), and lithium (Li). A single dopant, or two or more dopants may be added. By adding such a metal to the wurtzite crystal, the generation of cracks in the piezoelectric layer 13 can be suppressed.

The content of the dopant is, for example, from 0.1 at.% to 20 at.%, and preferably 0.1 at.% to 10 at.%. If the amount of the dopant is less than 0.1 at.%, The cracking suppressing effect may not sufficiently be obtained. If the amount of dopant exceeds 20 at.%, the piezoelectric characteristics of the piezoelectric layer 13 may be affected.

The addition of the dopant to the piezoelectric layer 13 is not essential. As will be described in more detail later, because of the adhesive layer 14 inserted between the piezoelectric layer 13 and the conductive film 15, a leakage current path is prevented from being generated between the conductive film 12 and the conductive film 15 even if pinholes or cracks are present on the surface of the piezoelectric layer 13.

The adhesive layer 14 may either be insulative or conductive. If the adhesive layer 14 is conductive, the adhesive layer 14 may serve as a part of the top electrode, together with the conductive film 15.

The adhesive layer 14 may be, for example, an acrylic adhesive layer, a silicone adhesive layer, or the like. These adhesives are transparent and suitably used when the piezoelectric device 10A is applied to a display. Alternatively, the adhesive layer 14 may be formed of an adhesive that contains an ultraviolet (UV) curable component and a binder polymer. The UV curable component may be a UV curable resin such as an oligoester acrylate or a urethane acrylate oligomer. A photopolymerization initiator may be mixed with such a UV curable resin.

A thermosetting component may be used, in place of the UV curable component. Examples of the thermosetting component include, but are not limited to epoxy resin, phenol resin, melamine resin, urea resin, polyester resin, urethane resin, acrylic resin, polyimide resin, benzoxazine resin, and mixtures thereof.

The binder polymer may be, for example, an acrylic polymer, a polyester resin, a urethane resin, a silicone resin, a rubber polymer, or the like.

When the adhesive layer 14 is a transparent conductive adhesive layer, the above-described transparent adhesive may be doped with metal nanoparticles. If the adhesive layer 14 is too thick, the electric charge generated in the piezoelectric layer 13 may be attenuated. Therefore, the thickness of the adhesive layer 14 is preferably 10 µm or less, more preferably 5 µm or less.

The conductive film 15 is used as a top electrode. When the adhesive layer 14 is conductive, the conductive film 15 and the adhesive layer 14 together form the top electrode. The conductive film 15 may be a transparent film of a conductive oxide such as ITO, IZO, IZTO, or IGZO, or alternatively, it may be a metal electrode formed of Al or Pt. When the piezoelectric device 10A is applied to a display such as a touch panel, it is desirable to use a transparent conductive film of ITO, IZO, IZTO, IGZO, or the like.

The piezoelectric device 10A can maintain good piezoelectric characteristics, while suppressing leakage current paths between the conductive film 12 and the conductive film 15, even when the piezoelectric layer 13 is formed of a crystalline inorganic material.

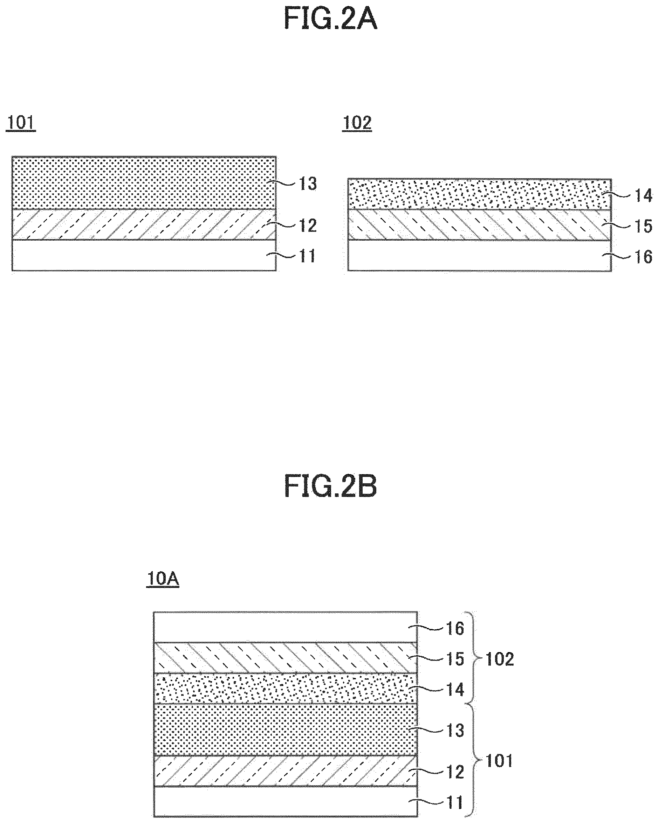

FIG. 2A and FIG. 2B illustrate a process of fabricating the piezoelectric device 10A of FIG. 1. In FIG. 2A, a first subassembly 101 and a second subassembly 102 that constitute the piezoelectric device 10A are fabricated. The first subassembly 101 has a conductive film 12 formed on a substrate 11, and a piezoelectric layer 13 formed on the conductive film 12. The conductive film 12 is, for example, an ITO film formed by sputtering at room temperature on the PET substrate 11 having a thickness of 50 to 100 µm.

A ZnO layer having a thickness of 50 to 400 nm is formed as the piezoelectric layer 13 on the conductive film 12. The ZnO layer may be formed by RF magnetron sputtering or DC magnetron sputtering using a ZnO target, in a mixed gas atmosphere of argon (Ar) with a very small amount of oxygen (O2). Thus, the first subassembly 101 is fabricated.

The second subassembly 102 is fabricated by forming the conductive film 15 on a substrate 16 and applying the adhesive layer 14 on the conductive film 15. In this example, the conductive film 15 is formed by sputtering an ITO film at room temperature on the PET substrate 16 having a thickness of 50 to 100 µm. The adhesive layer 14 having a thickness of 1 to 5 µm is formed on the conductive film 15. For the conductive film 15 and the adhesive layer 14, an ITO film with a transparent conductive adhesive layer may be used.

In FIG. 2B, the adhesive layer 14 of the second subassembly 102 is brought so as to face the piezoelectric layer 13 of the first subassembly, and the first subassembly 101 and the second subassembly 102 are bonded together by the adhesive layer 14. Thus, the piezoelectric device 10A is obtained. Because the adhesive layer 14 is provided between the piezoelectric layer 13 and the conductive film 15, a leakage current path is prevented from being generated between the conductive film 12 and the conductive film 15, even though there are pinholes or cracks existing in the piezoelectric layer 13. Consequently, the piezoelectric characteristics in the thickness direction can be maintained in the piezoelectric layer 13.

### <MODIFICATION>

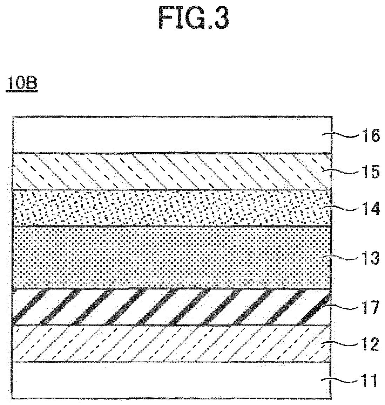

FIG. 3 illustrates a piezoelectric device 10B, which is a modification of the piezoelectric device of the embodiment. The piezoelectric device 10B has an amorphous orientation control layer 17 under the piezoelectric layer 13. In the piezoelectric device 10B, a conductive film 12, the orientation control layer 17, the piezoelectric layer 13, an adhesive layer 14, a conductive film 15, and a substrate 16 are provided in this order on a substrate 11. By providing the adhesive layer 14 between the piezoelectric layer 13 and the conductive film 15, a leakage current path can be prevented from being generated between the conductive film 15 and the conductive film 12. By providing the amorphous orientation control layer 17 under the piezoelectric layer 13, the crystal orientation of the piezoelectric layer 13 is improved.

The substrate 11 may be a glass substrate or a plastic substrate. When a plastic substrate is used, it may be a flexible plastic substrate that imparts flexibility to the piezoelectric device 10A. As the plastic substrate, polyethylene terephthalate (PET), polyethylene naphthalate (PEN), polycarbonate (PC), acrylic resin, cycloolefin polymer, polyimide (PI), etc. may be used.

Among these materials, PET, PEN, PC, acrylic resin, and cycloolefin polymer are colorless and transparent materials, and may be suitably used in applications requiring light transmission. If light transmission is not essential for the piezoelectric device 10A, for example, in applications to health-care products such as pulse rate monitors or heart rate monitors, or to vehicle pressure-sensor sheets, then a semitransparent or opaque plastic material may be used.

The conductive film 12 serves as a bottom electrode in the example of FIG. 1. The conductive film 12 is a transparent film of a conductive oxide such as indium tin oxide (ITO), indium zinc oxide (IZO), indium zinc tin oxide (IZTO), indium gallium zinc oxide (IGZO), or the like. Although transparency is not essential for the conductive film 12, a transparent conductive film formed of ITO, IZO, IZTO, IGZO, or the like is preferred when the piezoelectric device 10A is applied to a display such as a touch panel.

The orientation control layer 17 may be formed of an inorganic material, an organic material, or a mixture of an inorganic material and an organic material. As the inorganic material, silicon oxide (SiOₓ), silicon nitride (SiN), aluminum nitride (AlN), aluminum oxide (Al₂O₃), gallium nitride (GaN), gallium oxide (Ga₂O₃), and so on can be used. Alternatively, ZnO with Al₂O₃ and SiOₓ added (which is referred to as "SAZO" representing aluminum/silicon-added zinc oxide) may be used. GaN, AlN, ZnO or other base material to which at least one of Al₂O₃, Ga₂O₃, SiOₓ and SiN is added can also be used.

Examples of the organic material include, but are not limited to an acrylic resin, a urethane resin, a melamine resin, an alkyd resin, and a siloxane-based polymer. In particular, a thermosetting resin composed of a mixture of a melamine resin, an alkyd resin and an organic silane condensate can be preferably used as the organic material.

Using the above-described materials, an amorphous film can be formed by vacuum deposition, sputtering, ion plating, coating, or other appropriate methods. The orientation control layer 17 may be a single layer, or a multilayer with two or more films stacked. In the case of multilayer configuration, an inorganic thin film and an organic thin film may be laminated.

The amorphous orientation control layer 17 formed from the above-described materials is superior in surface smoothness, and the c-axis of the subsequently formed wurtzite crystal aligns in the direction vertical to the substrate (i.e., along the layer stacking direction). Further, the gas barrier performance is high, and adverse influence of the gas derived from a plastic during the film formation process, which tends to arise when a plastic substrate is used, can be reduced. In particular, when a thermosetting resin is used as the orientation control layer 17, a highly smooth amorphous layer is formed. When a melamine resin is used as the orientation control layer 17, the film density is high owing to the three-dimensional crosslinked structure and the barrier performance is good. The orientation control layer 17 is not necessarily 100% amorphous, and it may contain a non-amorphous portion as long as the c-axis orientation can be enhanced. The proportion of the amorphous part in the orientation control layer 17 is preferably 90% or more, more preferably, 95% or more, and further preferably, 100%.

The piezoelectric layer 13 is formed of an inorganic piezoelectric material, as in the piezoelectric device 10A of FIG. 1, and it has a wurtzite crystal structure. As the wurtzite-type piezoelectric material, zinc oxide (ZnO), zinc sulfide (ZnS), zinc selenide (ZnSe), zinc telluride (ZnTe), aluminum nitride (AlN), gallium nitride (GaN), cadmium selenide (CdSe), cadmium telluride (CdTe), silicon carbide (SiC), or the like can be used. A combination of two or more of the above-described compounds may be used. The combination may be provided as individual layers formed of the above-described compounds. The selected compound or a combination of two or more of these compounds may be used as the main component of the wurtzite, and an additional component may optionally be added as a subcomponent to the wurtzite crystal.

With any of the above-described piezoelectric materials, the c-axis orientation of the piezoelectric layer 13 is good because of the amorphous orientation control layer 17 provided as the underlying layer.

A metal dopant such as silicon (Si), magnesium (Mg), vanadium (V), titanium (Ti), zirconium (Zr), or lithium (Li) may be added to the wurtzite crystal. These metal dopants can maintain the non-conductive property of the wurtzite crystal when added to the wurtzite crystal. A single dopant, or two or more dopants may be added. By adding such a metal to the wurtzite crystal, cracking can be suppressed from being generated in the piezoelectric layer 13.

The adhesive layer 14 may either be an adhesive insulating layer or an adhesive conductive layer, and an acrylic adhesive layer, a silicone adhesive layer, or the like can be used as in the configuration of FIG. 1. When a conductive adhesive is used, the adhesive layer 14 may function as a part of the top electrode, together with the conductive film 15.

The conductive film 15 is used as the top electrode. When the adhesive layer 14 is conductive, the conductive film 15 and the adhesive layer 14 together form the top electrode. The conductive film 15 may be formed of a transparent conductive oxide such as ITO, IZO, IZTO, or IGZO. Although the transparency of the conductive film is not essential, it is desirable to use a transparent conductive film of ITO, IZO, IZTO, IGZO, or the like when the piezoelectric device 10B is applied to a display such as a touch panel.

In the piezoelectric device 10B, the c-axis orientation and the polarization performance in the thickness direction of the piezoelectric layer 13 are good because of the amorphous orientation control layer 17 provided under the piezoelectric layer 13. Further, by providing the adhesive layer 14, leakage current paths can be prevented from being generated between the conductive film 12 and the conductive film 15, and good piezoelectric characteristics are maintained.

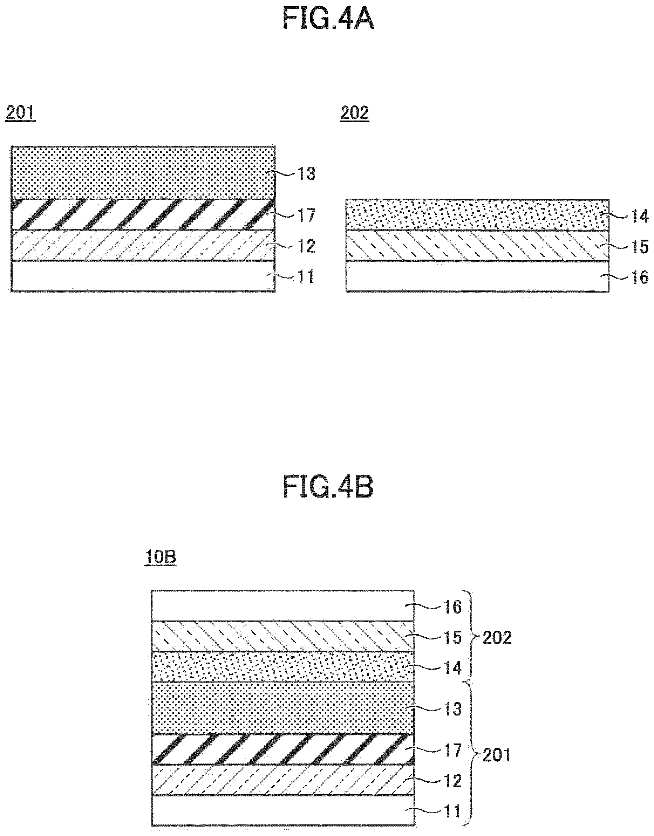

FIG. 4A and FIG. 4B illustrate a process of fabricating the piezoelectric device 10B of FIG. 3. In FIG. 4A, a first subassembly 201 and a second subassembly 202 that constitute the piezoelectric device 10B are fabricated. The first subassembly 201 is fabricated by forming a conductive film 12 on a substrate 11, and by forming an orientation control layer 17 and a piezoelectric layer 13 in this order on the conductive film 12. The conductive film 12, the orientation control layer 17, and the piezoelectric layer 13 may be successively formed by sputtering at room temperature.

The second subassembly 202 is fabricated by forming a conductive film 15 on a substrate 16 and applying an adhesive layer 14 on the conductive film 15. As the conductive film 15 and the adhesive layer 14, an ITO film with a transparent conductive adhesive layer may be used.

In FIG. 4B, the adhesive layer 14 of the second subassembly 202 is brought so as to face the piezoelectric layer 13 of the first subassembly 201, and the first subassembly 201 and the second subassembly 202 are bonded together by the adhesive layer 14. Thus, the piezoelectric device 10B is obtained. Because the orientation control layer 17 is provided under the piezoelectric layer 13, the c-axis orientation of the piezoelectric layer 13 is improved. Because the adhesive layer 14 is provided between the piezoelectric layer 13 and the conductive film 15, a leakage current path is prevented from being generated between the conductive film 12 and the conductive film 15, even though cracking occurs in the piezoelectric layer due to fine pinholes.

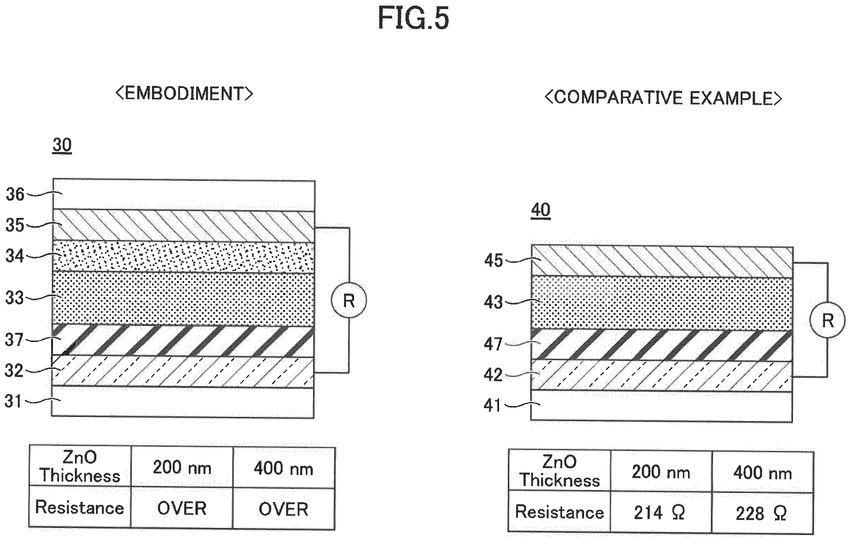

FIG. 5 shows evaluation results of the piezoelectric device of an embodiment, together with the evaluation results of a comparative example. For the configuration labelled as "EMBODIMENT" in FIG 5, samples 30 with the device structure of FIG. 3 are fabricated for measurement of the resistance values. For the "COMPARATIVE EXAMPLE" of FIG. 5, samples 40 without adhesive layers are fabricated for measurement of the resistance values.

As the samples 30, two samples with different thicknesses of the piezoelectric layer are prepared as follows. An ITO film having a thickness of 50 nm is formed as a lower electrode 32 on a PET substrate 31. An amorphous SAZO (ZnO to which Al₂O₃ and SiOₓ are added) film having a thickness of 10 nm is formed as an orientation control layer 37 by sputtering on the ITO film at room temperature. Two types of first subassemblys are fabricated, one has a ZnO layer having a thickness of 200 nm, and the other has a ZnO layer having a thickness of 400 nm, both ZnO layers serving as the piezoelectric layer 33 on the orientation control layer 37.

Meanwhile, the second subassemblys of the two samples are fabricated with the same structure and the dimensions by forming an Al film having a thickness of 100 nm as the top electrode 35 on the PET substrate 36, and applying an adhesive film having a thickness of 5 µm onto the Al film to form the adhesive layer 34.

Each of the first subassemblys is bonded to the corresponding second subassembly, thereby fabricating two samples 30 with different thicknesses of the piezoelectric layer 33.

The samples 40 of the comparative example are formed of the same materials at the same dimensions as the samples 30, except that the adhesive layer 34 is not provided. An ITO film is formed as a lower electrode 42 on a substrate 41, and an orientation control layer 47 formed of SAZO and having a thickness of 10 nm is provided onto the ITO film. Two types of layered structures, one has a ZnO layer having a thickness of 200 nm, and the other has a ZnO layer having a thickness of 400 nm, both being formed on the orientation control layer 47. Then, an Al film having a thickness of 100 nm is formed as a top electrode 45 on each of the layered structures.

With the two types of samples 30 of the embodiment and the two types of samples 40 of the comparative examples, the resistance is measured between the top electrode and the bottom electrode using an insulation resistance tester. As for the samples 30, regardless of the thickness of the piezoelectric layer 33, the needle measurable up to the megaohm (MΩ) order went off the scale in both samples, and the resistance value could not be obtained. This suggests that an electrical resistance of at least a megaohm is maintained between the bottom electrode 32 and the top electrode 35, and that almost no leakage current is generated.

As for the samples 40, the resistance value of the sample using the 200-nanometer-thick piezoelectric layer 43 is 214Ω, and the resistance value of the other sample using the 400-nanometer-thick piezoelectric layer 43 is 228Ω. Although the sample with the thicker piezoelectric layer indicates a slightly higher resistance value, a considerable amount of leakage current still flows in both samples.

It was confirmed from the evaluation results that by providing the adhesive layer between the piezoelectric layer and an electrode in the configuration of the embodiment, the leakage current path is suppressed between the electrodes, and polarization proportional to externally applied pressure can be detected accurately.

Although specific examples of the present invention have been described above, the present invention is not limited to the particulars of the above-described examples. For example, a thin-film glass may be used as the substrate 11 and/or the substrate 16.

In the embodiment, the conductive film 15 and the adhesive layer 14 are stacked in advance on the substrate 16 in the second subassembly 102 (or 202) of the piezoelectric device 10. However, the adhesive layer 14 may be omitted from the second subassembly, and only the conductive film 15 may be formed on the substrate 16 in the second subassembly. In this case, the conductive film 15 of the second subassembly is brought so as to face the piezoelectric layer 13 of the first subassembly, and an adhesive layer is provided between the first subassembly and the second subassembly to bond the first subassembly to the second subassembly.

The piezoelectric devices 10A and 10B described above are applicable to a piezoelectric actuator by making use of the inverse piezoelectric effect. Such an application includes, but not limited to an inkjet head.

The present application is based upon and claims priority to earlier filed Japanese Patent Application No. 2018-185551 filed September 28, 2018. The entirety of the earlier-filed Japanese patent application identified above is herein incorporated.

### Listing of Symbols

10A and 10B: piezoelectric device
11: substrate (first substrate)
12: conductive film (first conductive film)
13: piezoelectric layer
14: adhesive layer
15: conductive film (second conductive film)
16: substrate (second substrate)
17: orientation control layer
101, 201: first subassembly
102, 202: second subassembly

### <Prior Art Document(s)>

Patent Document 1: Japanese Patent Application Laid-open Publication No. 2011-222679

## Claims

1. A piezoelectric device comprising:
a first substrate;
a first conductive film provided on the first substrate;
a piezoelectric layer formed of an inorganic material and provided on the first conductive film;
an adhesive layer provided on the piezoelectric layer; and
a second conductive film provided on the adhesive layer.

2. The piezoelectric device as claimed in claim 1, further comprising:
an orientation control layer provided between the first conductive film and the piezoelectric layer.

3. The piezoelectric device as claimed in claim 1 or 2, wherein the piezoelectric layer has a wurtzite crystal structure.

4. The piezoelectric device as claimed in any one of claims 1 to 3, wherein a thickness of the piezoelectric layer is 50 nm to 400 nm.

5. The piezoelectric device as claimed in any one of claims 1 to 4, further comprising:
a second substrate provided on the second conductive film in a stacking direction,
wherein a first subassembly that includes the first substrate, the first conductive film and the piezoelectric layer is bonded by the adhesive layer to a second subassembly that includes the second conductive film.

6. The piezoelectric device as claimed in any one of claims 1 to 5, wherein the adhesive layer is a conductive.

7. The piezoelectric device as claimed in any one of claims 1 to 5,
wherein the second conductive film is transparent, and the adhesive layer is transparent insulative or transparent conductive.

8. A method of manufacturing a piezoelectric device, comprising:
fabricating a first subassembly by stacking a first conductive film on a first substrate and stacking a piezoelectric layer of an inorganic material on the first conductive film;
fabricating a second subassembly by stacking a second conductive film on a second substrate; and
bringing the second conductive film so as to face the piezoelectric layer and bonding the first subassembly and the second subassembly by an adhesive layer.

9. The method as claimed in claim 8,
wherein the second subassembly is fabricated by providing the second conductive film and the adhesive layer in this order on the second substrate, and
wherein the first subassembly and the second subassembly are bonded together such that the adhesive layer is sandwiched between the piezoelectric layer and the second conductive film.

10. The method as claimed in claim 8 or 9, further comprising:
forming an orientation control layer over the first conductive film,
wherein the piezoelectric layer is formed over the orientation control layer to form the first subassembly.
